# EUROPEAN PATENT APPLICATION

(11) **EP 1 965 443 A1**
(43) Date of publication of application: **03.09.2008**
(21) Application number: 06834959.6
(22) Date of filing: 19.12.2006
(51) Int. Cl.: H01L 33/00

(54) **OXIDE SEMICONDUCTOR LIGHT EMITTING ELEMENT**

(30) Priority: 20.12.2005 JP 2005366960
(71) Applicant: ROHM CO., LTD., Kyoto-shi, Kyoto 615-8585 (JP)
(72) Inventor: FUJII, Tetsuo, Kyoto 615-8585 (JP); TANABE, Tetsuhiro, Kyoto 615-8585 (JP)
(74) Representative: TBK-Patent
(86) International application number: PCT/JP2006/325249
(87) International publication number: WO 2007/072810

(57) **Abstract**

There is provided a ZnO based compound semiconductor light emitting device which can emit light with high efficiency and from an entire surface while using ZnO based compound semiconductor which can be expected with higher light emitting efficiency than that of a GaN based compound. On an insulating substrate (1), an n-type layer (2), an active layer (3), and a p-type layer (4), made of ZnO based compound semiconductor materials, are laminated, wherein a specific resistance of the n-type layer is 0.001 Ω · cm or more and 1 Ω · cm or less, and a film thickness (µ m) of the n-type layer is set in a value or more calculated by a formula (specific resistance (Ω · cm)) × 300, and an n-side electrode (5) is formed on an exposed portion of a surface of the n-type layer opposite to a surface being in contact with the substrate and a p-side electrode (6) is formed on the p-type layer.

## Description

### FIELD OF THE INVENTION

The present invention relates to a zinc oxide based (hereinafter referred to as ZnO based) compound semiconductor light emitting device such as a light emitting diode (LED) or the like using ZnO based semiconductor such as ZnO or a ZnO based compound formed by mixing Mg, Cd or the like to ZnO. More particularly, the present invention relates to a ZnO based compound semiconductor light emitting device having a structure capable of emitting light not from an n-side electrode side of a mesa structure only but from an entire surface of a chip with high efficiency.

### BACKGROUND OF THE INVENTION

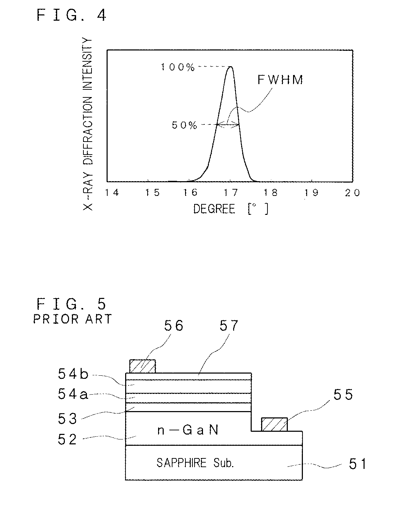

In recent years, a nitride semiconductor light emitting device such as a blue light emitting diode (LED), a laser diode or the like using nitride semiconductor has been in practical use. As a structure of an example of a LED is shown, for example, in Fig. 5, the blue semiconductor light emitting device of such kind is conventionally formed by laminating nitride compound semiconductor with elements of group III element (GaN based compound semiconductor) on a sapphire substrate 51 of an insulating substrate sequentially by a metal organic chemical vapor deposition (hereinafter referred to as MOCVD) method. Concretely, on the sapphire substrate 51, there are laminated sequentially a buffer layer not shown in the figure, an n-type GaN layer 52, an InGaN active layer 53, a p-type AlGaN barrier layer 54a and a p-type GaN contact layer 54b, a part of the n-type GaN layer 52 is exposed by etching a part of the laminated semiconductor layers by dry etching or the like as shown in Fig. 5, an n-side electrode 55 is formed thereon and a light transmitting electrode 57 and a p-side electrode 56 are formed respectively on the p-type contact layer 54b, thereby the LED is constituted (cf. PATENT DOCUMENT 1).

On the other hand, in a ZnO based compound semiconductor of an oxide semiconductor, since a binding energy of an exciton (exciton; a pair formed with an electron and a hole drawn by a Coulomb's force) thereof is very large such as 60 meV and larger than 26 meV of a thermal energy of a room temperature, the exciton can exist stably at a room temperature. Once the exciton is formed, it is apt to generate a photon easily. Namely, light is emitted with high efficiency. Therefore, it is known that the exciton emits light with remarkably higher efficiency than that of emitting light by direct recombination of a free electron and a free hole. Then, in recent years, there have been actively studied a semiconductor light emitting device using a ZnO based compound semiconductor layer which enables to achieve higher efficiency light emitting than that by a nitride semiconductor light emitting device.
PATENT DOCUMENT 1: Japanese Patent Application Laid-Open No. H10-173222 (Fig. 1)

### DISCLOSURE OF THE INVENTION

### PROBLEM TO BE SOLVED BY THE PRESENT INVENTION

Since the above-described ZnO based compound semiconductor light emitting device is formed mostly on an insulating substrate such as a sapphire substrate or the like similarly to a case of a nitride semiconductor light emitting device, an n-side electrode and a p-side electrode are required to be formed on the same side (a surface side of a semiconductor lamination portion), and there exists a portion where electric current flows in a direction (lateral direction to a paper surface of Fig. 5) perpendicular to a direction of laminating semiconductor layers. And, if such structure is employed to the ZnO based semiconductor light emitting device, a specific resistance of an n-type layer is large similarly to a case of the nitride semiconductor light emitting device, and if a film thickness is not sufficient for spread of electric current, the electric current flows mainly along the shortest distance to an active layer, and the electric current is concentrated in a region near the n-side electrode. As a result, also in case of forming ZnO based compound semiconductor layers on the insulating substrate, electric current is concentrated in an end portion of the mesa structure near the n-side electrode, and there arises a problem such that light is emitted only at an outer peripheral portion of the mesa.

In addition, even in an insulating substrate free structure which is formed by forming a thick film of a ZnO based compound semiconductor layer on an insulating substrate and removing the insulating substrate thereafter, if a resistance of the n-type layer is high, the problem of spread of electric current can not be solved and the electric current becomes to be concentrated at a part. As an area of electrode is reduced at a side of light output, the electric current is concentrated especially under the electrode, a region of light emitting is restricted under the electrode and a problem occurs such that the light is intercepted by the electrode.

The present invention is directed to solve the above-described problems and an object of the present invention is to provide a ZnO based compound semiconductor light emitting device which can emit light with high efficiency and from an entire surface while using ZnO based compound semiconductor which can be expected with higher light emitting efficiency than that of the GaN based compound.

### MEANS FOR SOLVING THE PROBLEM

In order to solve the problem such that light is emitted only at the outer peripheral portion of the mesa or that the specific resistance of the n-type layer contacted with the electrode is large and the thickness of the n-type layer is not sufficient for the spread of the electric current, the present inventors firstly suggested an idea of diffusing the electric current sufficiently by lowering the specific resistance of the n-type layer contacted with the n-side electrode by increasing quantity of an n-dopant similarly to a general method used in the nitride semiconductor light emitting device. However, it is found that a ZnO based compound doped in n-type conductivity has lower mobility than that of nitride semiconductor similarly doped, and the electric current can not be diffused sufficiently by a carrier concentration and a thickness of the n-type layer used in a nitride semiconductor based LED.

And, if a ZnO based compound semiconductor material having a low specific resistance is intended to be formed by increasing quantity of an n-dopant for an n-type layer, crystallinity of an active layer laminated thereon deteriorates rapidly, lowering of light emitting efficiency occurs more noticeably than in a case of the GaN based compound semiconductor, and, as a result, it is found that even light can be emitted from an entire surface, light emitting efficiency itself lowers. Concretely, the present inventors examined X ray diffraction intensity, as shown in Fig. 4, in order to judge crystallinity good or bad (a wide full width at half maximum means bad crystallinity) by forming ZnO based compound layers having various specific resistances for the n-type layer. Here, a full width at half maximum (FWHM) means a width of a curve at 50% intensity of the maximum intensity of the X ray diffraction intensity. Then, from the result, if the specific resistance is lowered too much, a value of the full width at half maximum becomes wider. In addition, being accompanied with deterioration of the crystallinity of the n-type layer, a photoluminescence intensity which is a standard of good or bad of light emitting efficiency becomes low. On the other hand, there is obtained a result such that the crystallinity is improved and the photoluminescence intensity increases when a value of the specific resistance is increased because a value of the full width at half maximum becomes small. It is spontaneously found that, in ZnO based compound semiconductor, an influence of the crystallinity to a value of the specific resistance is remarkably large as described above, and concretely, if the value of the specific resistance is not 0.001 Ω · cm or more, the active layer provided above can not be escaped from the influence and if the value of the specific resistance is not 1 Ω · cm or less, a driving voltage increases and practical use can not be achieved.

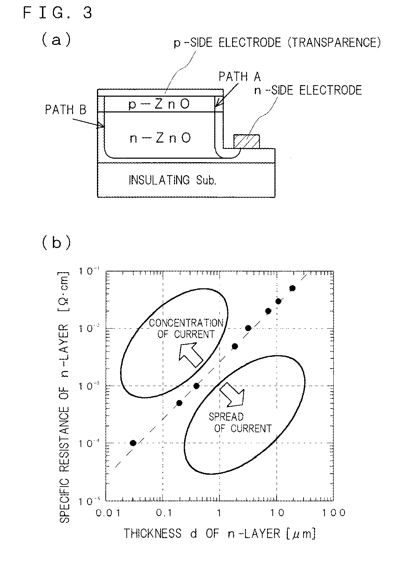

In addition, according to the above-described study, in case of using a value of the specific resistance which does not deteriorate the crystallinity, electric current can not be spread sufficiently depending on a thickness of the n-type layer, however the present inventors paid attention to a relationship of the value of the specific resistance and the film thickness and discovered a formula by which the thickness of the n-type layer and the value of the specific resistance which cause no lowering of a light emitting efficiency while keeping light emitting from an entire surface can be calculated by a mutual relationship of the thickness and the value of the specific resistance of the n-type layer contacted with the n-side electrode. Concretely, since the light emitting from the entire surface can be obtained if the electric current at a place 300 µ m away (size generally used in a semiconductor light emitting device) from the n-side electrode 3 is set to 50 % or more of the electric current at a vicinity of the n-side electrode, the present inventors earnestly studied the relationship of the film thickness and the specific resistance satisfying such conditions. As a result, as shown in Fig. 3, it is found that the electric current can be spread sufficiently if the film thickness d (µ m) of the n-type layer is a value obtained by a formula d=(specific resistance (Ω · cm)) × 300, or more.

Then, a zinc oxide based (ZnO based) compound semiconductor device of the present invention includes an n-type layer and a p-type layer laminated, an n-side electrode formed so as to contact with the n-type layer, and a p-side electrode formed so as to contact with the p-type layer, wherein a specific resistance of the n-type layer is 0.001 Ω · cm or more and 1 Ω · cm or less, and a film thickness d (µ m) of the n-type layer is set in a value or more calculated by a formula d=(specific resistance (Ω · cm)) × 300.

Here, the zinc oxide (ZnO) based compound semiconductor means an oxide including Zn, and means concretely besides ZnO, an oxide of one or more elements of group **II** A and Zn, an oxide of one or more elements of group **II** B and Zn, or an oxide of elements of group **II** A and group **II** B and Zn.

Concretely, the n-type layer and the p-type layer are formed on an insulating substrate and the n-side electrode is formed on an exposed portion of a surface of the n-type layer which is opposite to a surface contacted with the insulating substrate. Or the n-side electrode is formed on a surface of the n-type layer exposed by removing an insulating substrate used for growing the n-type layer and the p-type layer, and wherein a metal having a high reflection coefficient is used for the p-type electrode.

In addition, the n-type layer is a layer which is epitaxially grown by a MOCVD method.

### EFFECT OF THE INVENTION

According to the present invention, since the value of the specific resistance is 0.001 Ω · cm or more and 1 Ω · cm or less, the crystallinity of the n-type ZnO based compound semiconductor layer is not deteriorated, and also the crystallinity of the active layer laminated thereabove is maintained, thereby lowering of the light emitting efficiency caused by the deterioration of the crystallinity does not occur. And since the film thickness (µ m) is set to (specific resistance (Ω · cm)) × 300 or more, a driving voltage can be prevented from rising.

Further, since the thickness of the n-type layer is calculated by the formula considering a relationship with the value of the specific resistance, while maintaining the crystallinity of the n-type layer, a zinc oxide based semiconductor light emitting device of an entire surface light emitting type capable of spreading electric current sufficiently and having higher efficiency can be obtained. Namely, although light emitting intensity is proportional to an electric current density when the electric current is small, if the electric current does not spread sufficiently even when the crystallinity of the active layer is improved, increasing of the light emitting intensity shifts from a straight line when the electric current density becomes large by a factor of heat generation besides crystallinity deterioration, thereby the light emitting efficiency lowers. However, since local heat generation can be inhibited by spreading the electric current uniformly as in the present invention, a region where the light emitting efficiency is proportional to the electric current can be spread and higher efficiency can be achieved as a result.

In addition, by discovering the above-described relationship, even in a ZnO based semiconductor device, a semiconductor light emitting device with high light emitting efficiency can be obtained in a mesa structure in which an insulating substrate is used and an n-side electrode and a p-side electrode are formed on a surface side of crystal growth, or in employing an insulating substrate free structure. In addition, by forming the n-type layer by a MOCVD method, the n-type layer having a thickness which can not be achieved by crystal growth of a conventional MBE method can be easily formed, then a semiconductor light emitting device insuring more sufficient spread of the electric current can be manufactured.

### BRIEF DESCRIPTION OF THE DRAWINGS

Fig. 1 is an explanatory cross-sectional view of a LED of an embodiment of the ZnO based compound semiconductor device according to the present invention.
Fig. 2 is an explanatory cross-sectional view of a LED of another embodiment of the ZnO based compound semiconductor device according to the present invention.
Fig. 3 is a schematic figure showing an electric current flow of the light emitting device and a graph showing a relationship of a value of specific resistance of an n-type layer and a film thickness of the n-type layer.
Fig. 4 is an explanatory figure of X-ray diffraction estimating crystallinity of ZnO based compound semiconductor layer.
Fig. 5 is a figure showing an example of constitution of a LED by the prior art using GaN based compound semiconductor.

### EXPLANATION OF LTTERS AND NUMERALS

- 2:: n-type layer
- 4:: p-type layer
- 5:: n-side electrode
- 6:: p-side electrode

### THE BEST EMBODIMENT OF THE PRESENT INVENTION

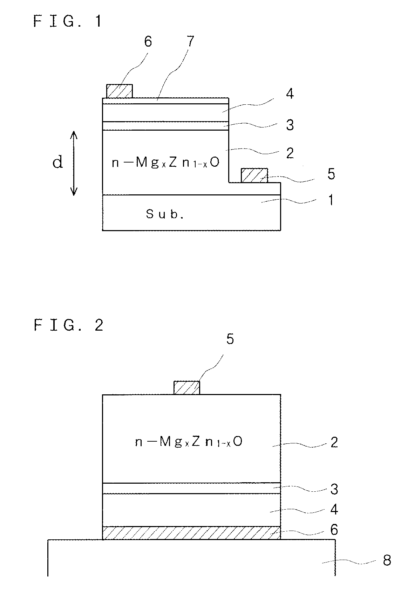

An explanation will be given below of a zinc oxide based compound semiconductor light emitting device according to the present invention in reference to the drawings. AS an explanatory cross-sectional view of a chip of an embodiment thereof is shown in Fig 1, the zinc oxide based compound semiconductor light emitting device according to the present invention is formed by laminating, on an insulating substrate 1, an n-type layer 2, an active layer 3, and a p-type layer 4, made of ZnO based compound semiconductor materials, wherein a specific resistance of the n-type layer is 0.001 Ω · cm or more and 1 Ω · cm or less, and a film thickness (µ m) of the n-type layer is set in a value calculated by a formula (specific resistance (Ω · cm)) × 300, or more, and forming an n-side electrode 5 on an exposed portion of a surface of the n-type layer opposite to a surface being in contact with the substrate and a p-side electrode 6 on the p-type layer.

As the insulating substrate 1, there may be used, for example, a MgᵥZn₁₋ᵥO (hereinafter also referred to as simply MgZnO based compound) substrate which is formed by mixing Mg with a mixed crystal ratio of 50 at% or less, and other substrate such as a sapphire substrate, a SCAM (ScAlMgO₄) or the like. In addition, on the surface of the insulating substrate 1, a relaxation layer, not shown in the figure, for relaxing lattice mismatching with compound semiconductor may be formed, for example, of ZnO and 0.1 µ m thick. In addition, the insulating substrate is not limited to an perfect insulator and includes a material which has a carrier concentration of 1×10¹⁷ cm⁻³ or less or a value of the specific resistance of 1 Ω · cm or more.

On the insulating substrate 1, at least the n-type layer 2 and the p-type layer 4 made of a ZnO based compound semiconductor material are laminated. Subsequently, the active layer 3 is formed between the n-type layer 2 and the p-type layer 4, and here it is preferable that a double hetero junction structure holding with the n-type layer 2 and the p-type layer 4 which are made of Mg_{z}Zn_{1-z}O (0≦ z≦ 1, for example z=0.1) having a band gap energy larger than that of the active layer 3 is formed, because light emitting efficiency can be enhanced by improving an effect of electric current confinement. Of course, a p-n junction formed by laminating directly the n-type layer 2 and the p-type layer 4 may be used without forming the active layer 3.

In case of providing the active layer 3, for example, there is formed a bulk structure made of MgₓZn_{y}Cd_{1-x-y}O (0 ≦ x ≦ 1, 0 ≦ y ≦ 1; for example x=0 and y=0.9), or a single quantum well structure or a multi quantum well structure formed by combining layers formed by varying x and y. In case of forming the bulk structure, for example, a layer made of MgₓZn_{y}Cd_{1-x-y}O (0 ≦ x ≦ 1, 0 ≦ y ≦ 1; for example x=0 and y=0.9) is formed with a thickness of approximately 50 nm, and in case of forming the multi quantum well structure, a lamination structure is formed which is composed of, for example, from a lower layer side, an n-type guide layer made of n-type Mg_{0.05}Zn_{0.95}O having a thickness of approximately 0 to 15 nm, a lamination portion formed by laminating a Mg_{0.1}Zn_{0.9}O layer having a thickness of approximately 6 to 15 nm and a ZnO layer having a thickness of approximately 1 to 5 nm, alternately six times, and a p-type guide layer made of p-type Mg_{0.05}Zn_{0.95}O having a thickness of approximately 0 to 15 nm, however the structure is not limited to these.

As described above, it is preferable that the n-type layer 2 and the p-type layer 4 are made of Mg_{z}Zn_{1-z}O (0 ≦ z ≦ 1; for example z=0.1) which has a larger band gap energy than that of the active layer 3, from the view point of improving the light emitting efficiency. For example, the p-type layer 4 is formed with a Mg_{0.1}Zn_{0.9}O layer having a thickness of approximately 0.3 µ m. In addition, a lamination structure of a barrier layer and a contact layer may be used, a gradient layer may be provided between layers of a hetero junction, and still, a reflection layer may be formed at a substrate side. For example, it may be suggested that the p-type layer 4 is formed with a lamination structure of a Mg_{0.1}Zn_{0.9}O layer for the barrier layer and a ZnO layer for the contact layer.

Then, the n-type layer 2 is formed so that a specific resistance thereof is 0.001 Ω · cm or more and 1 Ω · cm or less, and a film thickness d (µ m) thereof is in a value or more calculated by the formula d=(specific resistance (Ω · cm)) × 300.

As described above, the present inventors discovered that the value of the specific resistance is required to be set to 0.001 Ω · cm or more and 1 Ω · cm or less in order not to deteriorate the crystallinity without raising a driving voltage. However, when a lower limit of the specific resistance is specified in such manner, occasionally, the electric current may not spread sufficiently depending on the thickness of the n-type layer. Then, the present inventors paid further attention to a relationship of the value of the specific resistance and the film thickness, and discovered a formula of a mutual relationship of the film thickness and the value of the specific resistance of the n-type layer contacted with the n-side electrode, in which the film thickness can be calculated from the value of the specific resistance of the n-type layer not causing lowering of the light emitting efficiency by maintaining light emitting from an entire surface.

Namely, the reason why light emitting portions are concentrated at the n-side electrode side in case of the mesa structure and light emitting can not be obtained from the entire surface is that, as a schematic figure showing the electric current flows of a ZnO based compound semiconductor light emitting device of a p-n junction type is shown in Fig. 3(a), the electric current flowing into the n-side electrode flows passing the n-type layer near the n-side electrode (path A), and the electric current becomes not to flow sufficiently into the n-type layer far from the n-side electrode (path B), thereby light is emitted at only a part of the n-type layer.

Then, considering that light can be emitted at the entire surface of the light emitting device if design is carried out so that the electric current (path B) flowing into the n-type layer at a distance of 300 µ m (a size generally used in a semiconductor light emitting device) from the n-side electrode is 50% or more of the electric current (path A) flowing into the n-type layer near the n-side electrode, while the value of the specific resistance of the n-type layer is fixed, the present inventors estimated the minimum film thickness (which gives the electric current of 50% or more of the electric current flowing into the n-type layer near the n-side electrode) of the n-type layer which is required at the value of the specific resistance.
In addition, the value of the specific resistance of the n-type layer was varied variously, and the film thicknesses of the n-type layers required respectively were calculated.

And, a result of plotting the film thickness of the n-type layer calculated by the above-described method and the value of the specific resistance thereof is shown in Fig. 3(b). As shown in Fig. 3 (b) , by setting the value of the specific resistance and the value of the film thickness so as to be in the right region of a straight line formed by connecting points obtained respectively by the above-described method, the electric current (path B) flowing into the n-type layer at a distance of 300 µ m from the n-side electrode can be at least 50% or more of the electric current (path A) flowing into the n-type layer near the n-side electrode.

Therefore, it is found that, if the value of the specific resistance and the film thickness are set so as to be in the region of the electric current spread shown in Fig. 3(b), the electric current does not concentrate at a part, lowering of light emitting efficiency is not caused, and light emitting from the entire surface can be obtained. Namely, it is found that the electric current can spread sufficiently if values of the specific resistance and the film thickness have a relationship represented by the right region of the straight line shown in Fig. 3(b), or, concretely, a relationship in which the film thickness (µ m) is a value or more calculated by (specific resistance (Ω · cm)) × 300. For example, as recognized by the above-described Fig. 3(b), in case of an n-type ZnO layer having the value of the specific resistance of 0.005 Ω · cm, the film thickness of the n-type layer is required to be at least 1. 5 µ m or more, and in case of an n-type ZnO layer having the value of the specific resistance of 0.01 Ω · cm, the film thickness of the n-type layer is required to be at least 3 µ m or more.

The p-side electrode 6 is formed with a lamination structure of Ni/Au, Ti/Au or the like on a surface of the p-type layer 4 by a lift off method. In addition, in order to improve the spread of the electric current from the p-side electrode, a light transmitting electrode 7 made of a material (for example, ITO) which does not absorb light emitted at the active layer 3 is preferably formed before forming the p-side electrode 6 from the view point of achieving higher efficiency. On the other hand, after exposing the n-type layer 2 by etching and removing a part of the p-type layer 4, the active layer 3 and the n-type layer 2 until reaching the n-type layer 2 by dry etching or wet etching, the n-side electrode 5 is formed on the exposed portion by laminating Ti and Al by a lift off method. Thereafter, by dividing a wafer into chips after polishing a back surface of the insulating substrate 1 so that a thickness thereof is approximately 100µ m, the light emitting device chip shown in Fig. 1 is formed. In addition, positions and sizes of the n-side electrode 5 and the p-side electrode may be formed with other structures and materials used may be various known materials.

In order to manufacture the light emitting diode, a ZnO based compound is firstly grown, for example, on a sapphire substrate 1. For growing the ZnO based compound for forming the n-type layer 2, it is preferable to use a MOCVD apparatus provided with an organic metal source. Thus it is preferable to laminate the n-type layer by using the MOCVD apparatus, since the n-type layer is easily formed thicker because a growth speed is remarkably faster than that in growing by a conventional MBE apparatus, and there are inhibited deterioration of the crystallinity caused by lowering the value of the specific resistance of the n-type layer and, at the same time, deterioration of the crystallinity of the active layer laminated on the n-type layer, by increasing the film thickness even if the value of the specific resistance is not lowered so small (doping concentration is small), thereby a semiconductor light emitting device with high efficiency and emitting light from an entire surface can be obtained. And it is also preferable to form the n-type layer by using the MOCVD apparatus, since carbon of a methyl group, an ethyl group or the like contained in the organic metal is mixed into the n-type layer during crystal growth, and makes the n-type layer a layer which hardly generates cracks. A carbon concentration is preferably approximately 10¹⁶ m³ to 10¹⁹ cm⁻³. However, since it is not impossible to form the n-type layer by using the MBE apparatus, it is needless to say that the MBE apparatus described later may be used.

Concretely, after setting a wafer of, for example, a sapphire substrate (a MgZnO based compound substrate may be used) within a MOCVD apparatus, a temperature of the substrate is raised to 400 to 900 °C, a necessary dopant gas is introduced together with H₂, N₂ or a mixed gas thereof of a carrier gas, and chemical vapor deposition is carried out, thereby a semiconductor layer can be grown, and semiconductor layers with a desired mixed crystal ratio can be laminated by varying reaction gasses subsequently and varying flow rates thereof. In addition, as a reaction gas, there are used dimethyl zinc (ZnCH₃) or diethyl zinc (Zn (C₂H₅)₂) for a Zn source, oxygen, nitrogen oxide, oxygen carbide, water, alcohol or the like for an O source, cyclopentadienyl magnesium (Cp₂Mg) or the like for a Mg source, and as a dopant gas, trimethyl aluminium (TMA) for an n-type dopant gas of Al, trimethyl gallium (TMG) or the like is supplied. Then, by controlling reaction time, the thickness of the n-type layer 2 can be controlled. In such manner, by controlling the composition of the n-type layer 2, the value of the specific resistance by doping, a film thickness or the like, the value of the specific resistance and the film thickness which are in the above-described region can be obtained.

Thereafter, the wafer is taken out from the MOCVD apparatus and a part of the n-type layer 2, the active layer 3 and the p-type layer 4 are formed by a MBE apparatus, because a film with higher property is preferably formed for improving light emitting efficiency, and it is preferable to use a MBE apparatus which is equipped with a radical source generating oxygen radical which is oxygen gas enhanced in reaction activity by RF plasma, for crystal growth of the active layer 3 and the p-type layer 4. A radical source of the same type is prepared for nitrogen of a dopant of p-type ZnO. Metal Zn, metal Mg or the like having a purity of 6-N (99.9999%) or more is used for a Zn source, a Mg source and a Ga source (n-type dopant) and vaporized from a knudsen cell (evaporation source). A shroud in which liquid nitrogen flows is provided around the MBE chamber so that a wall surface is not heated by heat radiation from the cell or a heater for the substrate. Thereby, high vacuum of approximately 1×10⁻⁹ Torr can be maintained inside of the chamber. After setting a wafer in which the n-type layer 2 is formed on the substrate 1 made of a MgZnO based compound within the MBE apparatus, a thermal cleaning is carried out at a temperature of approximately 700 °C, the temperature of the substrate is lowered to approximately 600 °C, and the active layer 3 and the p-type layer 4 of the above-described constitution is formed sequentially. Of course, it is possible to use the above-described MOCVD apparatus.

Thereafter, the n-type layer 2 is exposed by etching a part of the laminated semiconductor layers by a RIE method or the like. And there are formed the n-side electrode 5 by forming a film of Ti/Al or the like on the exposed surface of the n-type layer 2, for example, by a vapor deposition method or the like using a lift off method, the light transmitting conductive layer 7 by forming a film made of ITO on a surface of the p-type layer by a vapor deposition method or the like, and additionally the p-side electrode 6 by forming a lamination structure of Ni/Au by a vapor deposition method using a lift off method. Thereafter, a back surface of the substrate 1 is polished to a thickness of approximately 100 µ m and the light emitting diode chip shown in Fig. 1 is obtained by dividing the wafer into chips by dicing or the like.

In the light emitting diode obtained in such manner, since the specific resistance of the n-type layer 2 is within a range of 0.001 to 1 Ω · cm, the crystallinity does not be deteriorate and the driving voltage does not rise. In addition, since the film thickness of the n-type layer is set so as to spread the electric current sufficiently, even in a mesa structure in which the n-side electrode 5 and the p-side electrode 6 are formed on the same side surface, light can be emitted with high efficiency and from an entire surface.

A zinc oxide based compound semiconductor light emitting device of another embodiment of the present invention is formed, as an explanatory cross-sectional view of a chip of the embodiment is shown in Fig. 2, by laminating an n-type layer 2, an active layer 3, and a p-type layer 4, made of ZnO based compound semiconductor materials, wherein a specific resistance of the n-type layer 2 is 0.001 Ω · cm or more and 1 Ω · cm or less, and a film thickness (µ m) of the n-type layer 2 is set in a value or more calculated by a formula (specific resistance (Ω · cm)) × 300, forming a p-side electrode 6 on the p-type layer 4, removing the insulating substrate 1 thereafter, and forming an n-side electrode 5 on a surface exposed by removing the insulating substrate 1.

In the zinc oxide based compound semiconductor light emitting device shown in Fig. 2, since the n-type layer 2 and the p-type layer 4 are formed on the insulating substrate, the insulating substrate is removed thereafter and the n-side electrode is formed on the n-type layer exposed by removing the insulating substrate, it is not necessary to form a mesa structure in which the n-side electrode 5 and the p-side electrode 6 are formed on the same surface, therefore a problem does not occur such that light emitting efficiency at an outer peripheral part of the mesa except the vicinity of the n-side electrode is low. However, for taking out light, as the n-side electrode 5 is formed on a part of the exposed n-type layer 2 in a constitution in which the insulating substrate is removed, it is difficult for electric current to flow in a region away from a portion covered with the n-side electrode 5 if a specific resistance of the n-type layer 2 is large, and then the electric current can not spread sufficiently. In addition, if the spread of the electric current in the n-type layer 2 is not sufficient, light emitting occurs at the active layer 3 right under the n-side electrode 5, emitted light is intercepted by the electrode, and a device which emits light sufficiently can not be obtained in case such that the n-side electrode 5 is not light transmitting. However, by the present invention, since the film thickness and the value of the specific resistance of the n-type layer are set properly, the electric current can be spread sufficiently to a periphery part of the chip, and the above-described problem does not arise.

Each constitution of the n-type layer 2, the active layer 3 and the p-type layer 4 and the method of crystal growth is similar to those explained above. Then, after laminating each layer, the p-side electrode 6 is formed on the p-type layer 4 of the surface side with a lamination structure of Ni/Au by a vapor deposition method or the like using a lift off method, thereafter the chip is mounted on a sub mount 8 by flip-chip bonding. Here, it is preferable to use a metal having a high reflection coefficient such as, for example, Al and Ag, or a lamination structure containing them because a semiconductor light emitting device with higher efficiency can be obtained. Thereafter, the insulating substrate 1 is removed by etching or the like, and the n-side electrode 5 is formed on an exposed surface of the n-type layer 2 by removing the insulating substrate 1.

### INDUSTRIAL APPLICABILITY

Characteristics of a light emitting device using zinc oxide based compound semiconductor, such as a LED, a laser diode or the like, and a transistor device such as a HEMT or the like can be improved and the present invention can be utilized in every kinds of electronic apparatus using such semiconductor devices.

## Claims

1. A zinc oxide based compound semiconductor light emitting device comprising:
an n-type layer and a p-type layer laminated;
an n-side electrode formed so as to contact with the n-type layer; and
a p-side electrode formed so as to contact with the p-type layer,
wherein a specific resistance of the n-type layer is 0.001 Ω · cm or more and 1 Ω · cm or less, and a film thickness d (µ m) of the n-type layer is set in a value or more calculated by a formula d=(specific resistance (Ω · cm)) × 300.

2. The zinc oxide based compound semiconductor light emitting device according to claim 1, wherein the n-type layer and the p-type layer are formed on an insulating substrate and the n-side electrode is formed on an exposed portion of a surface of the n-type layer which is opposite to a surface contacted with the insulating substrate.

3. The zinc oxide based compound semiconductor light emitting device according to claim 1, wherein the n-side electrode is formed on a surface of the n-type layer exposed by removing an insulating substrate used for growing the n-type layer and the p-type layer, and wherein a metal having a high reflection coefficient is used for the p-type electrode.

4. The zinc oxide based compound semiconductor light emitting device according to claim 2 or 3, wherein the n-type layer is a layer which is epitaxially grown by a MOCVD method.
